# EUROPÄISCHE PATENTSCHRIFT

(11) **EP 1 410 443 B1**
(45) Veröffentlichungstag und Bekanntmachung des Hinweises auf die Patenterteilung: **26.03.2008**
(21) Anmeldenummer: 02767237.7
(22) Anmeldetag: 19.07.2002
(51) Int. Cl.: H01L 29/778

(54) **FELDEFFEKTTRANSISTOR**
FIELD EFFECT TRANSISTOR
TRANSISTOR A EFFET DE CHAMP

(30) Priorität: 20.07.2001 DE 10135596
(43) Veröffentlichungstag der Anmeldung: 21.04.2004
(73) Patentinhaber: MicroGaN GmbH, 89081 Ulm (DE)
(72) Erfinder: Kohn,Erhard, 89081 Ulm (DE); Daumiller,Ingo, 88316 Isny (DE); Kunze, Mike, 89250 Senden (DE)
(74) Vertreter: Pfenning, Meinig & Partner GbR
(86) Internationale Anmeldenummer: PCT/EP2002/008102
(87) Internationale Veröffentlichungsnummer: WO 2003/012877

(56) Entgegenhaltungen:
- WO-A-00/21143
- WO-A-00/65663
- WO-A-01/92428
- GASKA R ET AL: "Two-channel AlGaN/GaN heterostructure field effect transistor for high power applications" JOURNAL OF APPLIED PHYSICS, 1 MARCH 1999, AIP, USA, Bd. 85, Nr. 5, Seiten 3009-3011, XP002227322 ISSN: 0021-8979
- PATENT ABSTRACTS OF JAPAN vol. 2000, no. 24, 11. Mai 2001 (2001-05-11) -& JP 2001 196575 A (MATSUSHITA ELECTRIC IND CO LTD), 19. Juli 2001 (2001-07-19) & US 2001/020700 A1 (INOUE ET AL.) 13. September 2001 (2001-09-13)

## Beschreibung

Die vorliegende Erfindung betrifft ein elektronisches Bauelement, wie es beispielsweise im Bereich des Mobilfunks oder der Radartechnik verwendet wird.

Insbesondere, aber nicht nur in diesen Bereichen, sind zur Erzeugung großer Leistungen hohe Stromdichten und große Durchbruchsspannungen der verwendeten Feldeffekttransistoren notwendig. Ein weiteres wichtiges Kriterium für die dort verwendeten Leistungstransistoren, die bei hohen Frequenzen große Leistungen erzeugen sollen, ist die Linearität dieser Bauelemente. Eine hohe Linearität des Feldeffekttransistors bedeutet eine große Bandbreite im Frequenzbereich, die insbesondere im Mobilfunkbereich von Bedeutung ist, um den Einfluss des Nebensprechens zu minimieren.

Piezoelektrische Felder in GaN/InGaN-Heterostrukturen spielen auch dann eine wesentliche Rolle, wenn diese Strukturen als strahlungsemittierende Halbleiterchips (Leuchtdiode) eingesetzt werden. In WO 00/21143 weist die aktive Schicht in einer solche Heterostruktur eine Einfach- oder Mehrfach-Quantenwell-Struktur auf. Um den das Strahlungsverhalten solcher Halbleiterchips beeinträchtigenden Einfluss der piezoelektrischen Felder in den Quantenfilmen zu eliminieren, werden diese Felder durch Dotierung möglichst vollständig beseitigt.

Aus R. Gaska et al., Journal of Applied Physics, 1999, AIP, USA, Band 85, Nr. 5 S. 3009 und WO 00/65663 sind Heterostrukturfeldeffekttransistoren mit zwei Kanälen bekannt, welche vor allem für Anwendungen mit großen Leistungen verwendet werden. Hier werden Schichtsysteme aus AlGaN und GaN gebildet.

Beispielsweise aus Wang et al "A High Current Pseudomorphic A1GaAs/InGaAs Double Quantum-Well MODFET", IEEE Electron Decive Letters, Vol. 9, No. 1, 1988, sind in den klassischen Materialsystemen GaAs und InP sogenannte Doppelkanalstrukturen zur Erhöhung der Stromdichte und der Linearität der Feldeffekttransistoren bekannt. Aufgabe der vorliegenden Erfindung ist es, elektronische Bauelemente zur Verfügung zu stellen, die eine hohe Linearität besitzen und große Leistungen erzeugen können.

Diese Aufgabe wird durch das elektronische Bauelement nach Anspruch 1 gelöst. Vorteilhafte Weiterbildungen des erfindungsgemäßen elektronischen Bauelementes werden in den abhängigen Ansprüchen gegeben. Weiterhin werden Verwendungen derartiger elektronischer Bauelemente in den Ansprüchen 46 und 47 gegeben.

Kern der vorliegenden Erfindung sind Mehrkanalstrukturen mit komparativer Piezoladung in einem polaren Materialsystem mit Kompensationsdotierung. Die Erfindung betrifft also eine Heterostruktur, die mindestens zwei übereinander angeordnete Quantentöpfe aufweist. Dabei wird unter Quantentopf eine Abfolge einer Pufferschicht, einer Kanalschicht und einer Deckschicht verstanden. Die Funktion der Pufferschicht oder der Deckschicht übernimmt bei der Abfolge zweier Quantentöpfe gegebenenfalls eine entsprechend aufgebaute Zwischenschicht. Eine derartige Heterostruktur ermöglicht die Herstellung beispielsweise eines Feldeffekttransistors mit hoher Stromdichte, hoher Linearität und hoher Bandbreite. Die Schichtabfolge besteht also aus einer Pufferschicht, einer Kanalschicht, einer Zwischenschicht, einer weiteren Kanalschicht und einer Deckschicht. Diese Schichtenfolge ist gewöhnlich auf einem Substrat angeordnet, so daß die Substratschicht üblicherweise mit der Pufferschicht eine Grenzfläche bildet. Im Falle eines Feldeffekttransistors können entweder vergraben in der Pufferschicht oder auf der Deckschicht oder ebenfalls in der Deckschicht vergraben, eine Source-Elektrode, eine Gate-Elektrode sowie eine Drain-Elektrode angeordnet sein. Statt lediglich zweier Kanäle können auch noch weitere Zwischenschichten und Kanalschichten in der Schichtfolge zwischen der Pufferschicht und der Deckschicht angeordnet sein, so daß ein System mit einer Vielzahl von Quantentöpfen entsteht. Eine besondere Ausführungsform ergibt sich dann, wenn die Zwischenschicht und die Kanalschicht jeweils nur wenige Nanometer Dicke aufweisen und eine Vielzahl derartiger Schichten aufeinanderfolgen. In dem Fall entsteht ein sogenanntes "Superlattice" (Übergitter)mit dem eine sehr hohe Stromdichte, sehr hohe Linearität und Breitbandigkeit des Bauelements erzielt werden kann.

Erfindungsgemäß enthalten bzw. bestehen die Kanalschichten aus einem piezopolaren Material, idealerweise aus AlGaN oder InGaN, die jeweils zwischen einer GaN-Pufferschicht oder einer (Al)GaN-Deckschicht angeordnet sind. Dabei ist die Kanalschicht aufgrund der unterschiedlichen Gitterkonstanten von GaN und InGaN bzw. A1GaN verspannt. Materialbedingt entstehen dadurch im GaN/InGaN/GaN-System piezoelektrische Felder, die an den Grenzflächen polarisierte Ladungen (Piezoladungen) erzeugen. Eine GaN/InGaN/GaN-Heterostruktur besitzt dabei eine positive Grenzflächenladung am InGaN/GaN und eine negative Grenzflächenladung am GaN/InGaN-Übergang (Interface). Der Vorteil dieser Struktur besteht darin, daß die durch die piezoelektrischen Felder erzeugten Ladungen sich im Kanal befinden. Aufgrund der Materialeigenschaften von GaN bilden sich zusätzlich spontane Polarisationsladungen an der Oberfläche und der Pufferrückseite, die jedoch nur einen sekundären Einfluß auf die Transistoreigenschaften haben.

Auch im AlGaN/ GaN-System führen Verspannungen zu piezoelektrischen Feldern, die an den Grenzflächen polarisierte Ladungen bilden. Im Gegensatz zu einem GaN/InGaN/GaN-System befinden sich nicht beide Grenzflächenladungen im Kanal, sondern die negative Ladung am AlGaN/GaN-Interface als 2DEG (2-dimensionales Elektronengas) und die positive Ladung an der AlGaN-Oberfläche.

Der Nachteil einer solchen Struktur ist, daß die gebundene Grenzflächenladung an der A1GaN / GaN-Grenzfläche mit der gegenpoligen Oberflächenladung durch die polarisierenden Feldern in Wechselwirkung zueinanderstehen. Die Oberflächenladungen nehmen im DC-Betrieb eines GaN-basierenden Transistors wenig Einfluß auf die Ausgangscharakteristik. Im RF-Betrieb muß die Ladung an der Oberfläche der Kanalladung aufgrund ihrer Wechselwirkung folgen. Vorausgesetzt die Ladungen im Kanal bewegen sich mit höherer Geschwindigkeit als die Oberflächenladungen, so folgt bei einer charakteristischen Frequenz im RF-Betrieb die Oberflächenladung nicht mehr der Kanalladung. Diese jetzt gegenpolige quasi ortsfeste Ladung verletzt die Neutralitätsbedingung und kann nun die freien Ladungen im Kanal einfangen, mit der Konsequenz, daß der Ausgangsstrom abnimmt und die maximale RF-Leistung sich gegenüber der DC-Leistung reduziert.

Im Gegensatz zum AlGaN/GaN-System befindet sich im GaN/InGaN/GaN-System keine durch die piezoelektrische Polarisation erzeugte Grenzflächenladung an der Probenoberfläche. Eine Wechselwirkung zwischen piezoelektrischer Polarisationsladung und oberflächenladung wird vermieden. Dadurch wird der Effekt der Stromkompensation und dem resultierenden Leistungsabfall bei höherfrequenter Eingangsleistung, der bei AlGaN/GaN-Transistoren zu beobachten ist, verhindert.

In einer GaN/InGaN/GaN tragen zum Stromtransport die positive Grenzflächenladung am rückseitigen InGaN/GaN-Interface und die induzierte negative Grenzflächenladung am GaN/InGaN vorderseitigen Interface bei. Im Vergleich zu GaN oder AlGaN ist die Elektronenbeweglichkeit in InGaN wesentlich höher und kann nach theoretischen Berechnungen 4500cm²/Vsec betragen. Die Beweglichkeit von Löchern ist im InGaN allerdings um ein Vielfaches geringer als die Elektronenbeweglichkeit. Der resultierende Nettostromfluß gegeben durch die positive Grenzflächenladung und negative Grenzflächenladung, ist bestimmt durch die Bedingung der Ladungsneutralität, d. h. der langsamere Löcherstrom bestimmt die resultierende Grenzfrequenz des Bauelements. Zudem kann der Kanal durch einen pn-Übergang gesperrt werden.

Erfindungsgemäß werden nun jeweils im Bereich der Grenzfläche zwischen einer Kanalschicht und einer benachbarten Schicht Dotierungen eingebracht, die eine der Ladungsträgerarten in der Kanalschicht kompensieren bzw. teilweise kompensieren. Damit verbleibt im Kanal lediglich die andere Ladungsträgerart, die dann ausschließlich bzw. überwiegend zum Stromtransport beiträgt. Beispielsweise kann durch eine dünne n-Dotierung im Kanal oder im Puffer bzw. sogar auch in dem Bauelemente-Substrat die positive Polarisationsladung an der Grenzfläche zwischen Puffer und Kanal kompensiert werden, so daß nur ein Elektronenkanal resultiert.

Entscheidend bei der vorliegenden Erfindung ist nun, daß eine Mehrzahl (mindestens 2) von Kanalschichten übereinander angeordnet werden. Dadurch kann eine erhebliche verbesserte Linearität des Bauelementes erzeugt werden. Alternativ kann auch im einen Kanal eine n-Leitung und im anderen Kanal eine p-Leitung erzeugt werden, so daß Logikschaltungen wie bei CMOS-Feldeffekttransistoren erzeugt werden können.

Für die Kompensationsdotierung kann einerseits eine Dotierung jeweils für jeden Kanal zwischen die Kanalschicht und die benachbarte Schicht eingebracht werden, so daß für jeden Kanal eine eigene Kompensationsschicht entsteht. Alternativ genügt es auch, nur in der Grenzschicht zwischen dem am weitest außenliegenden Kanal und der benachbarten Pufferschicht bzw. Deckschicht eine ausreichende Dotierung vorzunehmen, so daß die entsprechenden Ladungsträger in sämtlichen Kanälen kompensiert werden. Natürlich ist es auch möglich, lediglich im Bereich der Grenzflächen bestimmter Kanalschichten eine Dotierung einzubringen.

Erfindungsgemäß ist es also möglich, beispielsweise eine Vielzahl von InGaN-Kanalschichten durch GaN-Zwischenschichten voneinander getrennt, übereinander anzuordnen. Selbstverständlich ist eine entsprechende Ausbildung auch mit AlGaN-Kanalschichten möglich. InGaN-Kanalschichten und AlGaN-Kanalschichten können auch im selben Bauelement verwendet werden, beispielsweise um Logikschaltungen zu erzeugen.

Im folgenden werden einige Beispiele erfindungsgemä-ßer elektronischer Bauelemente beschrieben. Dabei bezeichnen in sämtlichen Figuren gleiche oder ähnliche Bezugszeichen gleiche oder ähnliche Elemente.

Es zeigen
- Fig. 1: eine erfindungsgemäße Mehrkanalstruktur im (Al)GaN/In(Ga)N/(Al)GaN-Heterostrukturmaterialsystem;
- Fig. 2: eine DC-Ausgangskennlinie der Struktur aus Fig. 1;
- Fig. 3: den Steilheitsverlauf eines GaN/InGaN/GaN-Doppelkanal-Heterostruktur-FET im Vergleich zum Steilheitsverlauf für eine GaN/InGaN/GaN-Heterostruktur-FET mit lediglich einem Kanal;
- Fig. 4: in den Teilfiguren 4a und 4b jeweils einen Heterostruktur-FET mit lediglich einer Kompensationsdotierung (Fig. 4a) bzw. mit weiter reduziertem In-Gehalt in den Kanalschichten (Fig. 4b);
- Fig. 5: eine DC-Ausgangskennlinie der Struktur aus Fig. 4a;
- Fig. 6: den Steilheitsverlauf eines GaN/InGaN/GaN-Doppelkanal-Heterostruktur-FET mit einer Kompensationsdotierung wie in Fig. 4a;
- Fig. 7: einen GaN/InGaN/GaN-Mehrkanal-Heterostruktur-FET mit Kompensationsdotierung im InGaN-Kanal;
- Fig. 8: ein (Al)GaN/In(Ga)N/(Al)GaN-Heterostrukturmaterialsystem mit dotiertem oder undotiertem Superlatis als Kanalsystem;
- Fig. 9: in den Teilfiguren 9a und 9b ein (A1)GaN/In(Ga)N/(A1l)GaN-Mehrkanal-Heterostrukturmaterialsystem mit n-Kanal und unterschiedlicher Anzahl Kompensationsschichten zur Realisierung von CMOS-ähnlicher Technologie;
- Fig. 10: eine p-(A1)GaN/In(Ga)N/(A1)GaN-Struktur mit einem p- und einem n-Kanal in Fig. 10a und eine entsprechende Schichtabfolge wie in Fig. 10a mit Strukturierung als p- und n-Kanal FELT;
- Fig. 11: eine (Al)GaN/In(Ga)N/(Al)GaN-Struktur mit einem n- und p-Kanal FET mit vergrabenen n⁺- und p⁺-Kontakten;
- Fig. 12: ein p-Kanal GaN/ A1GaN/GaN-FELT;
- Fig. 13: eine GaN/ A1GaN/GaN und GaN/InGaN/GaN-Mehrkanal-Struktur mit p- und n-Kanal (Fig. 13a) und eine Realisierung eines p- und n-Kanal-FET mit gleicher Schichtfolge wie in Fig. 13a (Fig. 13b).

In sämtlichen nachfolgenden Beschreibungen von Figuren bezeichnen die Bezugszeichen 1 ein erfindungsgemäßes Bauelement, 2 ein Substrat, 3 eine Pufferschicht, 4 (4a, 4b, ...) eine Kompensationsschicht (Dotierschicht), 5 (5a, 5b, ...) eine Spacer-Schicht, 6 (6a, 6b, ...) eine Zwischenschicht, 7 (7a, 7b ...) eine Kanalschicht, 8 eine Deckschicht, 9 eine Source-Elektrode, 10 eine Drain-Elektrode und 11 eine Gate-Elektrode (Steuerelektrode). In den Figuren ist, sofern wesentlich für die jeweilige Ausführungsform, sowohl die Schichtdicke der einzelnen Schicht, ihre Dotierung sowie ihre Zusammensetzung angegeben.

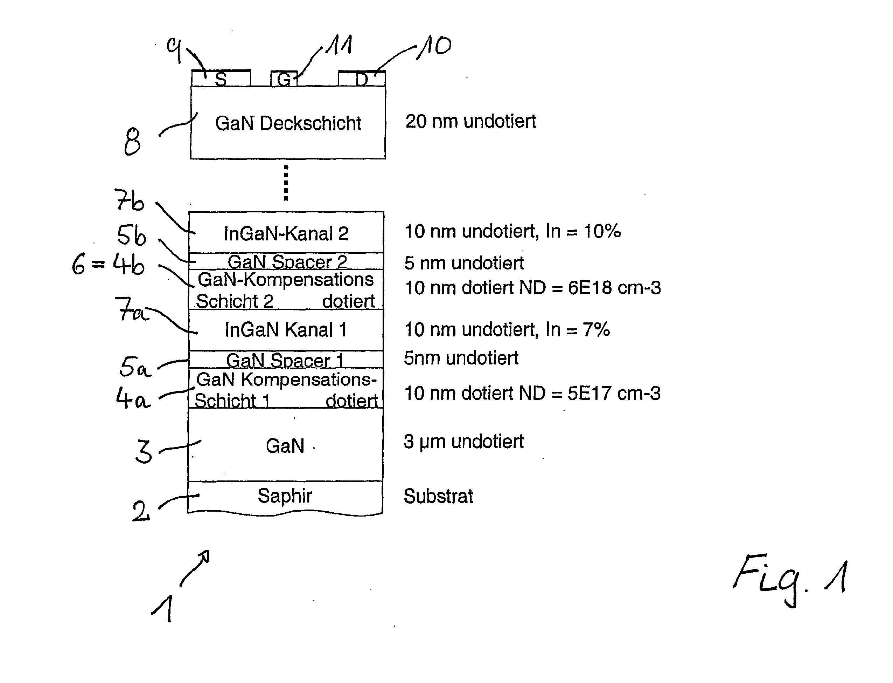

Der Schichtaufbau eines In(Ga)N Heterostrukturfeldeffektransistors mit zwei Quantentöpfen ist beispielhaft in Fig. 1 zu sehen. Auf einem Substrat 2 wird eine Pufferschicht 3 aus (Al)GaN gewachsen. Infolge von positiv polarisierten Ladungen an der nachfolgenden GaN/ InGaN-Grenzfläche zu einer Kanalschicht aus InGaN ist eine Donator-Kompensationsdotierung zur Erzeugung eines Elektronenkanals notwendig. Die erste Donator-Kompensationsdotierung zur Kompensation der positiven Ladungen aus dem ersten In(Ga)N-Kanal wird in einer (Al)GaN-Schicht 4a platziert. Darauf folgt ein undotierter (Al)GaN-Spacer 5a zur Trennung von Dotierrümpfen und freien Elektronen. Es folgt der erste In(Ga)N-Kanal 7a. Die Kompensation der zweiten positiven Ladungen erfolgt ebenfalls durch eine Kompensationsdotierung in einer zweiten (A1) GaN-Schicht 4b als Zwischenschicht 6 mit anschließendem zweiten (A1) GaN-Spacer 5b. Es folgt der zweite In(Ga)N-Kanal 7b mit einer abschließenden (A1) GaN Deckschicht 8.

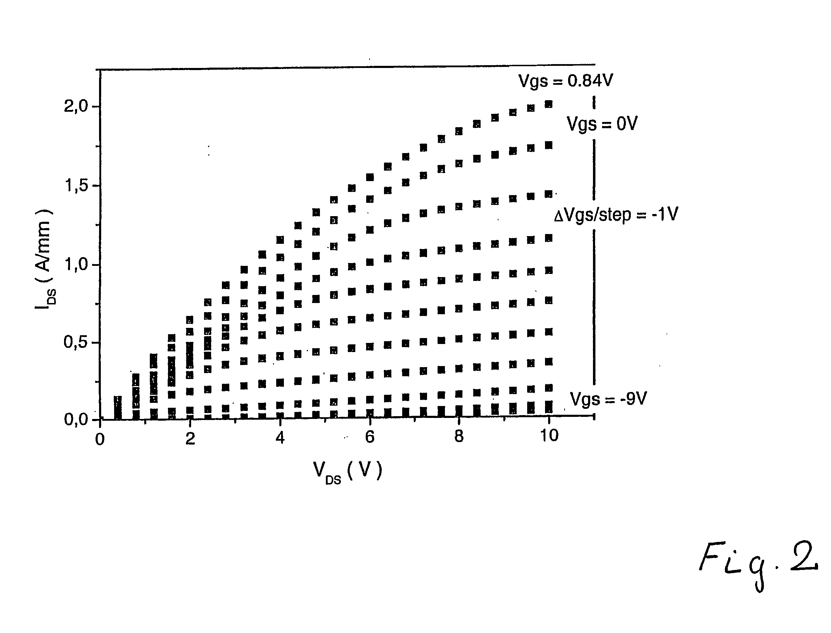

Die Gleichstrom-Ausgangskennlinie ist in Fig. 2 gezeigt und ergibt für die Struktur aus Fig. 1 einen maximalen Strom von 2 Ampere pro Millimeter bei einer Abschnürspannung von -9 Volt.

Die Linearität des Transistors wird dabei in erster Linie durch die Konfiguration des Schichtaufbaus bestimmt. Ein Maß für die Linearität ist der Steilheitsverlauf der Ausgangskennlinie. Je konstanter der Steilheitsverlauf über der Gate-Source-Spannung ist, desto linearer ist das Bauelement. Damit kann eine höhere Breitbandigkeit erzielt werden. Herkömmliche Strukturen zeigen näherungsweise einen glockenformigen Verlauf der Steilheit über die Gate-Source-Spannung. Dieser zeichnet sich nur durch einen schmalen, im Maximum der Glockenkurve konstanten Bereich aus, wodurch die Breitbandigkeit eingeschränkt ist.

Durch das Hinzufügen eines zweiten Kanals resultiert ein zweites Plateau im Steilheitsverlauf, das im Leistungsbetrieb eine größere Breitbandigkeit ermöglicht als ein Transistor mit nur einem Kanal.

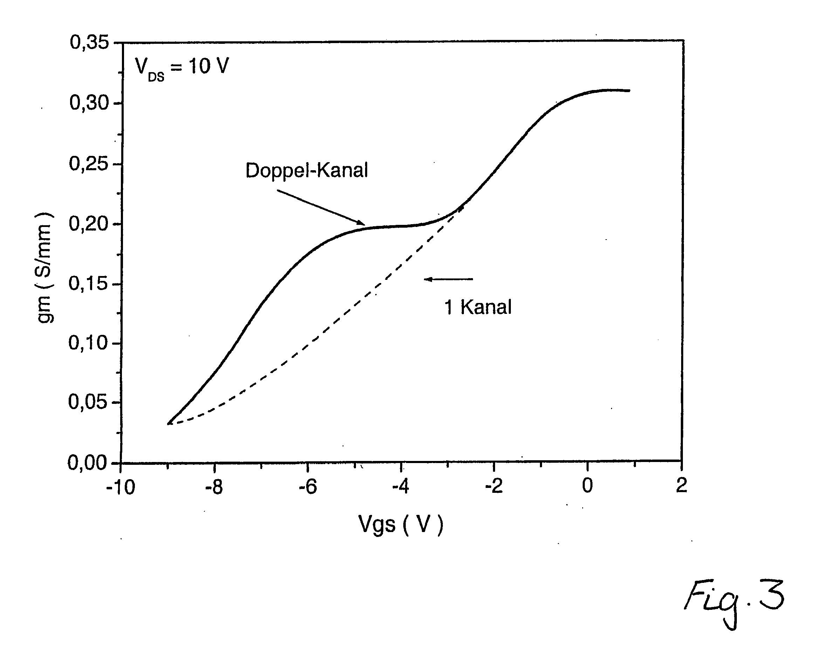

In Fig. 3 ist der Steilheitsverlauf aus der DC-Kennline aus Fig. 2 zu sehen. Deutlich ist das zweite Plateau, verursacht durch den ersten InGaN-Kanal, zu sehen. Im Vergleich dazu ist auch der Steilheitsverlauf mit nur einem InGaN-Kanal eingezeichnet.

Mit einer wie in Fig. 1 dargestellten (Al)GaN/In(Ga)N/(Al)GaN-Doppelkanal-Heterostruktur mit Kompensationsdotierung (im Falle der Fig. 1 für jeden Quantentopf extra) ist es folglich möglich, die maximale Stromdichte, die Linearität und die Breitbandigkeit gegenüber einer Struktur mit nur einem Kanal signifikant zu erhöhen.

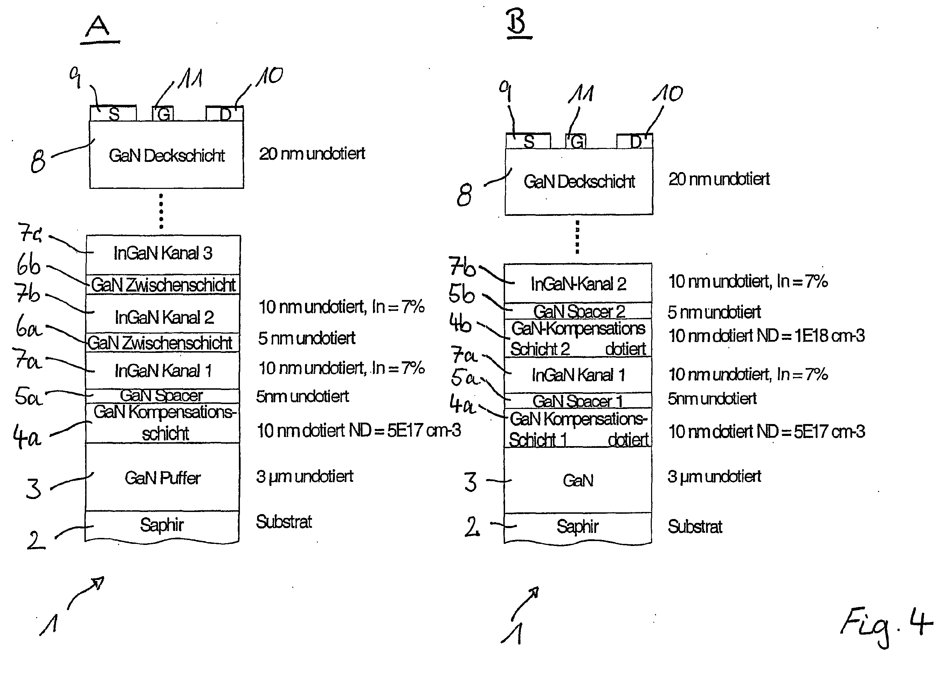

Ist zur Leistungserzeugung kein höherer Strom erforderlich, kann der In-Gehalt im In(Ga)N-Kanal reduziert werden und dabei die Materialqualität erhöht werden. Dabei sind u.a. zwei Konfigurationen im (Al)GaN/In(Ga)N/(Al)GaN Schichtaufbau möglich:
1) (Al)GaN/In(Ga)N/(Al)GaN-Mehrfachkanal-Heterostrukturfeldeffekttransistor mit reduziertem In-Gehalt ohne Kompensationsdotierung in jedem Quantentopf sondern mit nur einer Kompensationsdotierung unterhalb des ersten Quantentopfs wie in Fig. 4a dargestellt.
2) (Al)GaN/In(Ga)N/(Al)GaN-Mehrfachkanal-Heterostrukturfeldeffekttransistor mit Kompensations-dotierung in jedem Quantentopf entsprechend Fig. 1 mit reduziertem In-Gehalt wie in Fig. 4b dargestellt.

In Fig. 4a ist eine Mehrkanalstruktur zu sehen, bei der nur eine Kompensationsdotierung in einer Schicht 4a unterhalb des ersten Quantentopfs 7a platziert ist. In den weiteren Quantentöpfen 7b, 7c, ... kann auf eine zusätzliche Kompensationsdotierung verzichtet werden. In Fig. 4b ist demgegenüber für jeder der Kanalschichten 7a,7b,...eine eigene unter der jeweiligen Kanalschicht 7a, 7b,...angeordnete Kompensationsschicht 4a, 4b,...vorgesehen, die von der Kanalschicht durch eine GaN-Abstandshalterschicht (Spacerschicht) 5a, 5b getrennt ist.

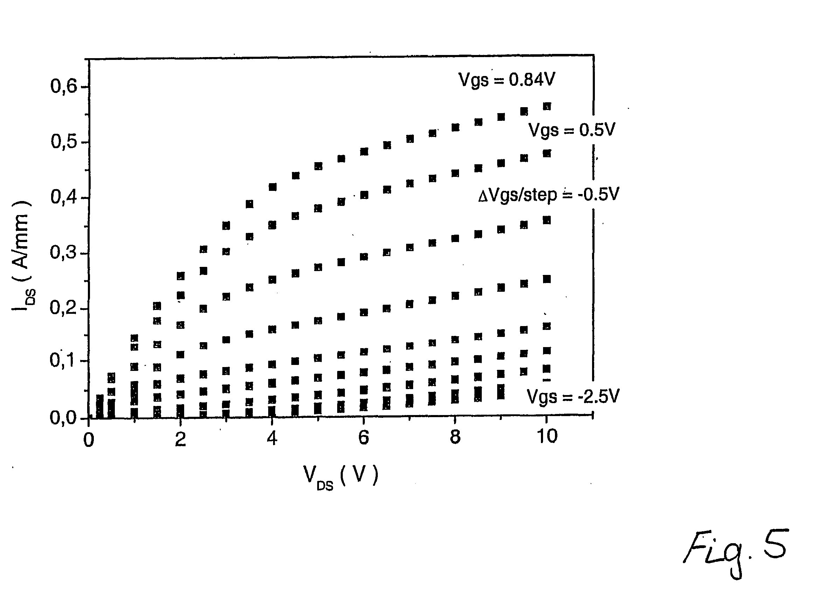

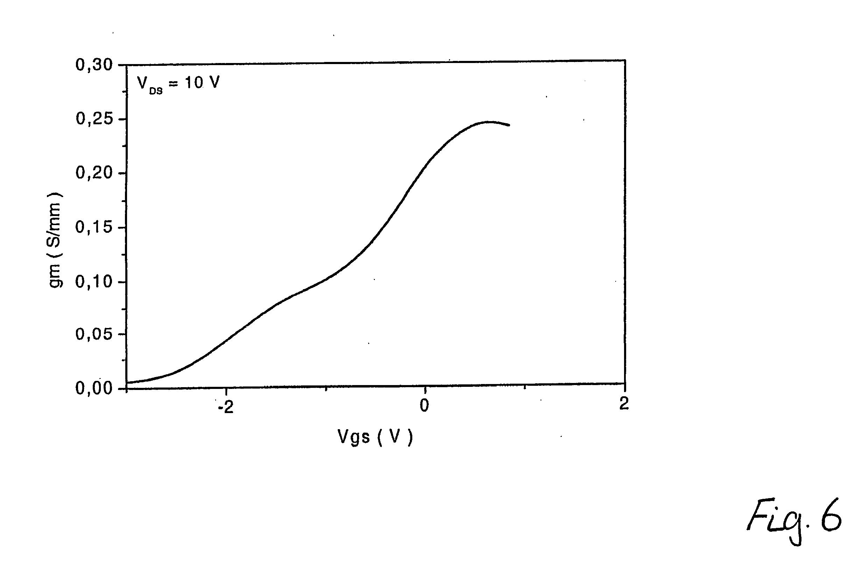

Die in Fig. 5 dargestellte Gleichstrom-Ausgangskennlinie für die Struktur aus Abbildung 4a ergibt einen maximalen Strom von 0,55 Ampere pro Millimeter bei einer Abschnürspannung von -2,5 Volt. In Fig. 6 ist der gerechnete Steilheitsverlauf aus der DC-Kennline in Fig. 5 dargestellt. Das zweite Plateau, verursacht durch den ersten InGaN-Kanal, ist im Bereich unterhalb -1 Volt Gate-Source-Spannung zu sehen.

Dieses Beispiel zeigt, daß mit einer (A1) GaN/In (Ga)N/ (A1)GaN-Mehrkanal-Heterostruktur mit nur einer Kompensationsdotierung beim ersten Quantentopf oder mit Kompensationsdotierungen bei jedem Quantentopf einzeln es auch bei reduziertem In-Gehalt möglich ist, die Materialqualität sowie die Linearität und Breitbandigkeit des jeweiligen Bauelementes weiter zu erhöhen.

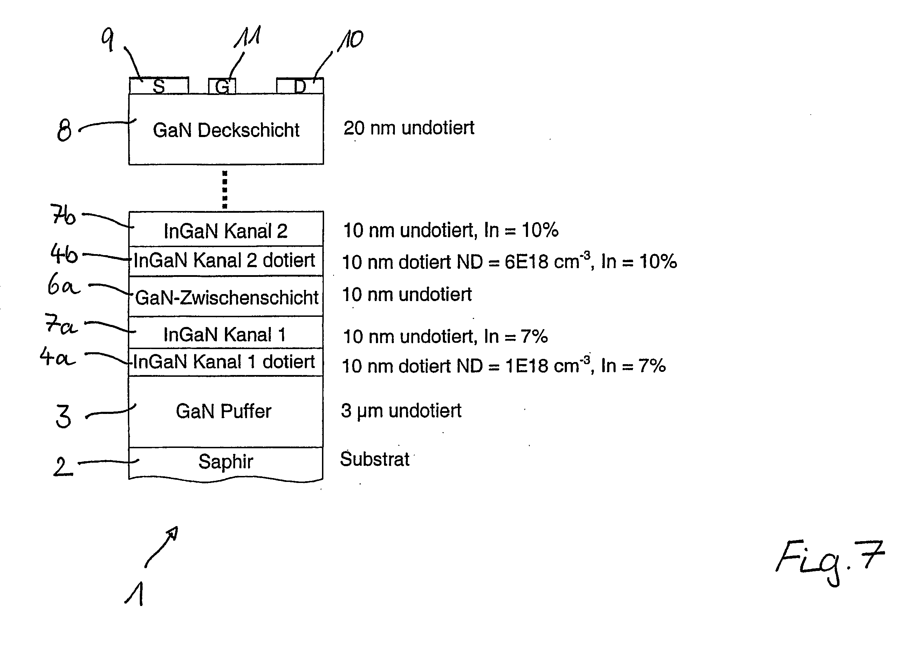

Die notwendige Donator-Kompensationsdotierung in einer eigenen vom Kanal getrennten, z.B. in der Pufferschicht angeordneten, (A1) GaN-Kompensationsschicht in Fig. 1 und Fig. 4a kann ersetzt werden durch eine Kompensationsdotierung in einem Teil der Kanalschicht. Ein Schichtaufbau eines In(Ga)N-Mehrkanal-Heterostrukturfeldeffektransistors mit zwei Quantentöpfen und einer Dönator-Kompensations-dotierung in einem Teil des jeweiligen In(Ga)N-Kanals 7a, 7b ist in Fig. 7 zu sehen.

Fig. 7 ist ein Beispiel dafür, wie mit einer (Al)GaN/In(Ga)N/(Al)GaN-Mehrkanal-Heterostruktur mit einer Donator-Kompensationsdotierung in einem Teil des jeweiligen In(Ga)N-Kanals 7a, 7b es möglich ist, die Stromdichte, sowie die Linearität und Breitbandigkeit der Bauelemente zu erhöhen. Eine Trennung der durch Dotierung in der Kanalschicht 7a bzw. 7b ausgebildeten Kompensationsschicht 4a, 4b von dem undotierten Bereich der Kanalschicht 7a, 7b durch eine Spacerschicht erfolgt hier nicht.

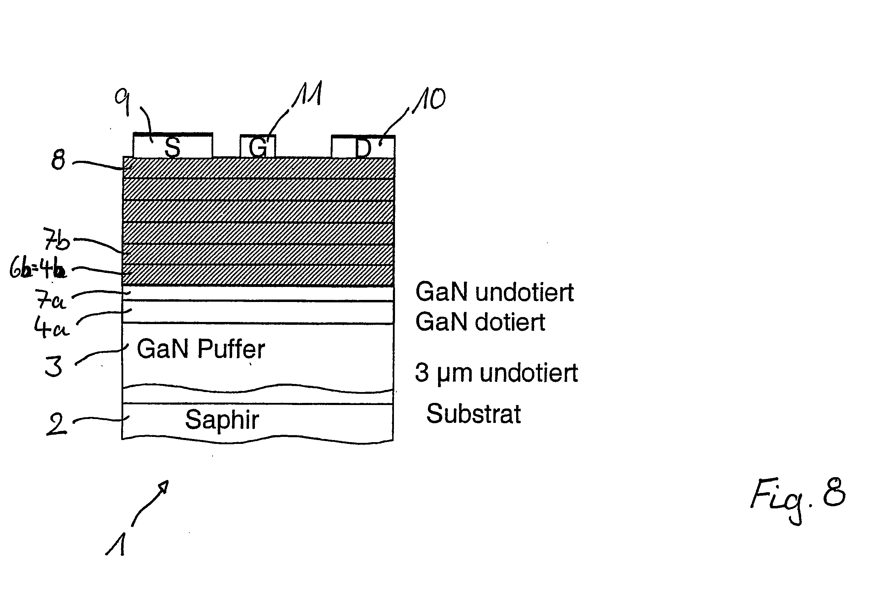

Reduziert man die Dicke der In(Ga)N/(Al)GaN-Quantentöpfe, so überlagern sich die Wellenfunktionen der einzelnen Quantentöpfe und das physikalisch/elektrische Verhalten der sonst diskreten Quantentöpfe in der Mehrkanalstrukturen verändert sich. Dadurch ist es möglich, das zweidimensionale Gas freier Ladungsträger (z.B. 2 DEG), das bei den diskreten Quantentöpfen der Mehrkanalstrukturen auftritt, in eine dreidimensionale Ladungsträger-Verteilung zu überführen. Dabei wird das Steuerverhalten der freien Ladungsträger beeinflusst. Desweiteren ist mit einer derartigen "Superlattice" als Gitterstruktur eine weitere Verbesserung der Materialqualität erzielbar bei gleichzeitiger Erhöhung des In-Gehaltes und/oder Al Gehaltes im In(Ga)N/(Al)GaN Quantentopfes bis hin zum InN/AlN System. Ein derartiges Superlattice 1 mit einer Abfolge von Zwischenschichten 6a, 6b, ...und Kanalschichten 7a, 7b,...ist in Fig. 8 dargestellt. Die Dicke der Zwischenschichten und der Kanalschichten beträgt ca. 3nm.

Die Kompensationsdotierung erfolgt im Superlattice entweder in den Zwischenschichten 6a, 6b,...aus (A1) GaN wie in Fig. 1, in der Kanalschicht 7a, 7b aus In(Ga)N wie in Fig. 7 oder lediglich zu Beginn des Superlattice" also in der Pufferschicht 3 oder einer Deckschicht 8 wie beispielsweise in Fig. 4a. Eine Zwischenform der Anordnung der Kompensationsschichten ist ebenfalls möglich.

Dieses Beispiel zeigt, wie mit einer (A1) GaN/In (Ga)N/(A1) GaN-Superlattice-Heterostruktur mit Donator-Kompensationsdotierung es möglich ist, die Materialqualität und insbesondere die Beweglichkeit der Ladungsträger zu verbessern. Dadurch resultiert eine höhere Stromdichte, eine höhere Linearität und Breitbandigkeit der Bauelemente.

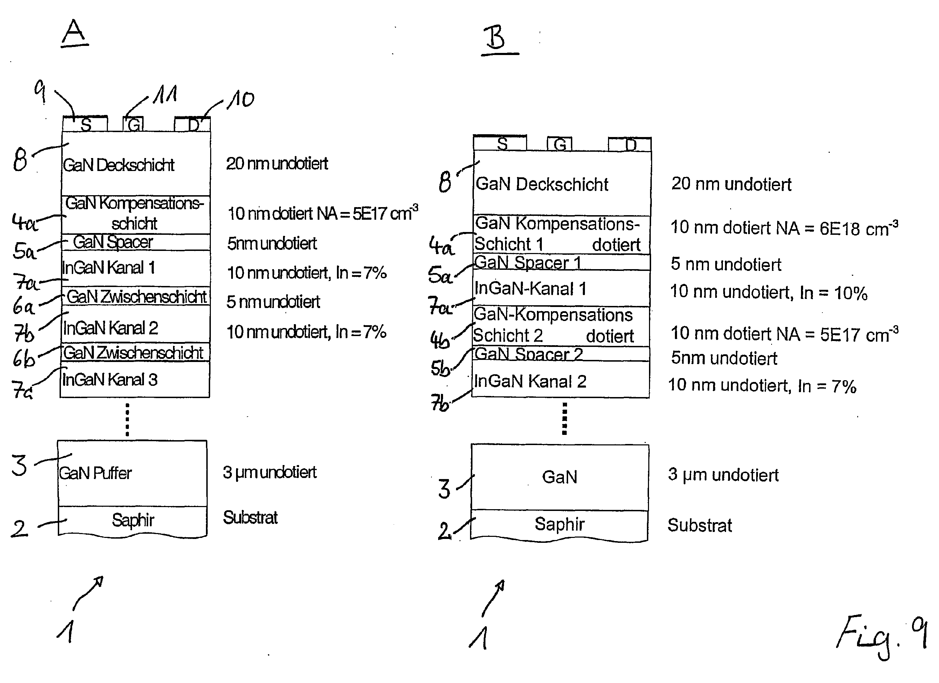

Um einen frei-beweglichen positiven Löcherkanal zu erzeugen, werden analog zu einem n-Kanal FET die nicht benötigten Elektronen durch eine Akzeptordotierung kompensiert. Dabei sind wieder im Falle InGaNbasierender Heterostrukturen zwei Möglichkeiten denkbar:
eine Kompensationsdotierung zu Beginn des GaN/InGaN Multiquantenwells (s. Fig. 9a), d.h. in der Deckschicht 8 oder
eine Dotierung in dem jeweiligen Quantenwell für jeden Quantentopf einzeln (s. Fig. 9b).

Selbstverständlich ist es auch möglich, eine Kompensationsdotierung lediglich für eine bestimmte Auswahl oder Anzahl von Quantentöpfen vorzunehmen.

Aufgrund der negativen und positiven Polarisationsladungen sind in einem (A1) GaN/In (Ga)N / (Al)GaN Materialsystem Elektronen und Löcher zu gleichen Teilen vorhanden. Es ist dadurch möglich, n-leitende (Elektronen-) und/oder p-leitende (Löcher-) Kanäle zu erzeugen. Dabei wird jeweils die gewünschte Ladungsträgerart durch die geeignete Wahl der Kompensationsdotierung erzielt. Für einen Elektronenkanal werden die Löcher durch eine Donatordotierung bzw. für einen Löcherkanal die Elektronen durch eine Akzeptordotierung kompensiert.

Dadurch ist es möglich, mit einer (A1) GaN/In (Ga)N/ (A1) GaN-Struktur gleichzeitig eine n- und/oder p-Leitfähigkeit zu erzeugen. Dies ermöglicht den Aufbau CMOS-artiger logischer Schaltungen unter der Verwendung von (A1) GaN/In (Ga)N/(A1)GaN Strukturen ohne zur Herstelllung des Beuelementes ein verfahrenstechnisch aufwendiges selektives Wachstum durchzuführen. Die Separation der beiden Transistortypen kann leicht durch Strukturierung lediglich mittels Ätzverfahren erfolgen.

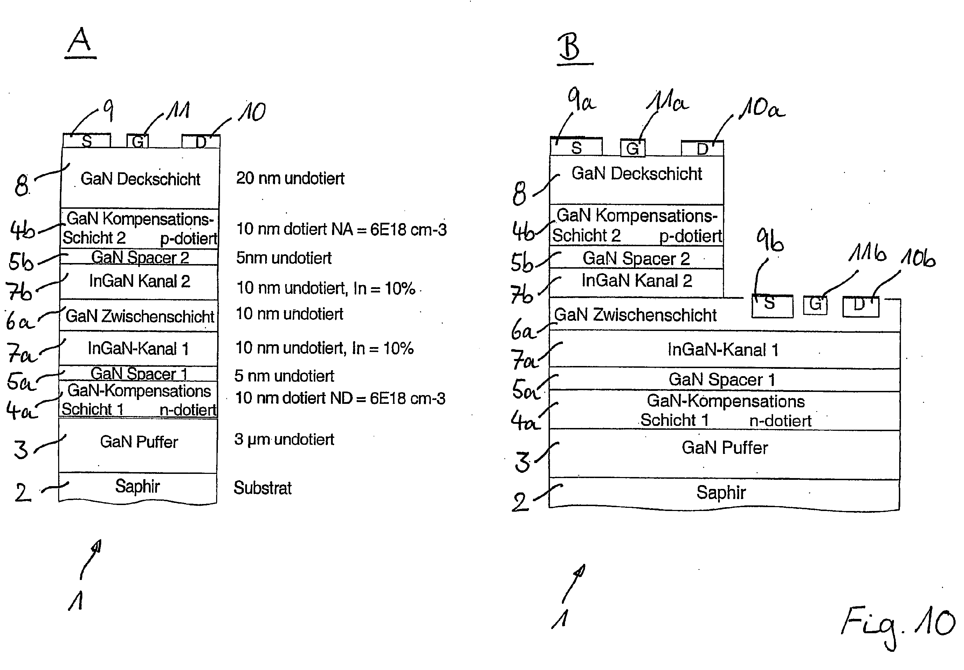

In Fig. 10a ist beispielhaft die Struktur 1 einer derartigen (Al)GaN/In(Ga)N/(Al)GaN-Schicht-Struktur mit einem p-Kanal 7b und n-Kanal 7a zu sehen. Auf einem Substrat 2 wird dazu ein (Al)GaN Puffer 3 gewachsen. Es folgt eine donatordotierte (Al)GaN Schicht 4a (erzeugt z.B. durch Dotierung eines Teils der Pufferschicht 3)zur Kompensation der Löcher im ersten In(Ga)N Kanal und darauf eine (A1) GaN-Spacer-Schicht 5a. Darauf ist die erste Kanalschicht 7a aufgebracht. Dann ist eine (Al)GaN Zwischenschicht 6a erforderlich. Es folgt der zweite In(Ga)N Kanal 7b mit anschließendem Spacer 5b und akzeptordotierter (Al)GaN Schicht 4b (erzeugt z.B. durch Dotierung eines Teils der nachfolgenden Deckschicht 8)zur Kompensation der freien Elektronen im zweiten In(Ga)N-Kanal 7b. Als Deckschicht 8 folgt eine (Al)GaN Schicht. Auf der Deckschicht 8 sind dann Sourceelektrode 9, Gateelektrode 11 und Drainelektrode 10 angeordnet.

Der wirksame Elektronenkanal befindet sich in der Heterostruktur in Fig. 10a zwischen der (A1) GaN Zwischenschicht 6a und dem ersten In(Ga)N Kanal 7a; der wirksame Löcherkanal zwischen der (A1) GaN Zwischenschicht 6a und dem zweiten In(Ga)N Kanal 7b.

Fig. 10b zeigt die mögliche technische Realisierung eines p- und n-Kanal FETs aus nur einer Schichtfolge und ohne selektives Wachstum. Hierzu wird zuerst eine Heterostruktur nach Fig. 10a hergestellt. Der n-Kanal FET mit der n-leitenden Kanalschicht 7a wird dann durch Rückätzen des in Fig. 10a dargestellten Schichtaufbaus in einem Teilbereich bis auf die (Al)GaN Zwischenschicht 6a hergestellt. Die (Al)GaN Zwischenschicht 6a dient dabei als Deckschicht für den n-Kanal FET, auf die dann eine Sourceelektrode 9b, eine Gateelektrode 11b und eine Drainelektrode 10b aufgebracht werden. Der p-Kanal FET funktioniert mit den Elektroden 9a, 10a und 11a im oberen Bereich bis zur (Al)GaN Zwischenschicht 6a mit der p-leitenden Kanalschicht. Jeder der beiden FET dieser Logikschaltung 1 aus Fig. 10b kann selbst wieder mehrere Kanalschichten aufweisen zur Verbesserung seiner eigenen Linearität und Leistung.

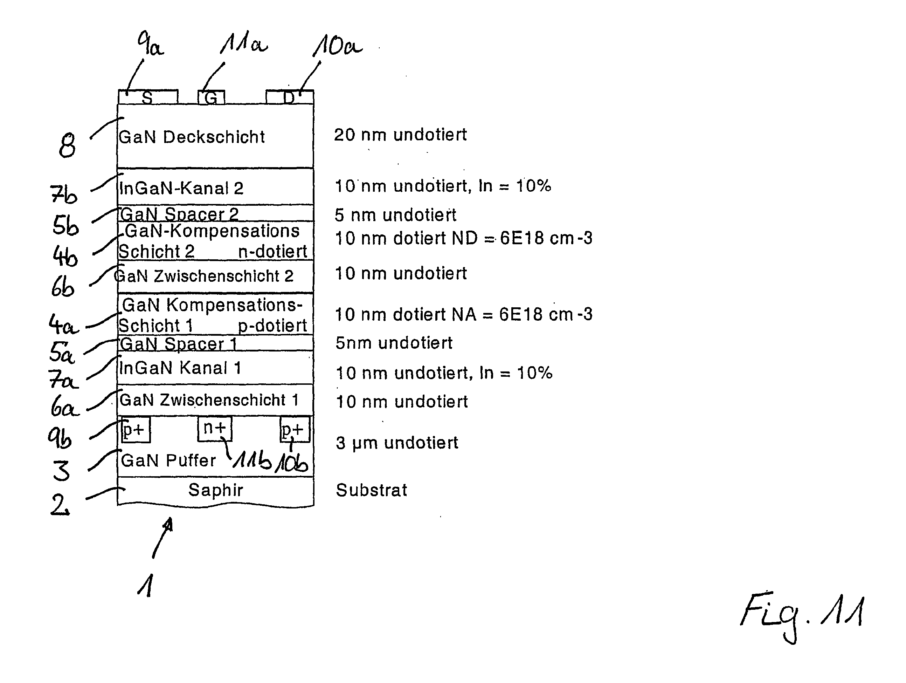

Die (Al)GaN/In(Ga)N/(Al)GaN-Heterostruktur in Fig. 10a kann auch invertiert werden, d.h. mit einem wirksamen Elektronenkanal zwischen bzw. an der Grenzfläche zwischen (A1)GaN Deckschicht 8 und dem zweiten In(Ga)N Kanal 7b sowie einem wirksamen Löcherkanal zwischen bzw. an der Grenzfläche zwischen (A1) GaN Puffer 3 und dem ersten In(Ga)N Kanal 7a. Dies ist in Fig. 11 dargestellt. Dabei erfolgt die Kontaktierung des p-Kanal 7b durch vergrabene n⁺ -und p⁺-Rückseitenkontakte 9b, 10b, 11b im GaN-Puffer 3. Der n-Kanal 7b befindet sich auf der Oberseite der Schicht mit den Kontaktelektroden 9a, 10a und 11a.

Mit dem in den Figuren 10 und 11 dargestellten (A1) GaN/In (Ga)N/ (A1)GaN Mehrkanal-Heterostrukturmaterialsystem ist es möglich durch geeignete Kompensationsdotierung einen n-Kanal und einen p-Kanal ohne selektives, d.h. lateral strukturiertes Wachstum zu erzeugen. Es können nunmehr ohne Maskentechniken zuerst sämtliche Schichten übereinander und ohne seitliche Strukturierung aufgebaut werden. Die Freilegung der einzelnen FETs der Logikschaltung 1 erfolgt dann durch bereichsweises Abätzen der den jeweiligen FET überdeckeden Schichten. Die Kontaktelektroden werden bereits zuvor vergraben angeordnet oder nachträglich auf die so freigelegte Oberfläche aufgebracht. Dies ermöglicht die Realisierung von CMOS-ähnlichen Strukturen und Schaltungen in einem piezoelektrischen Materialsystem.

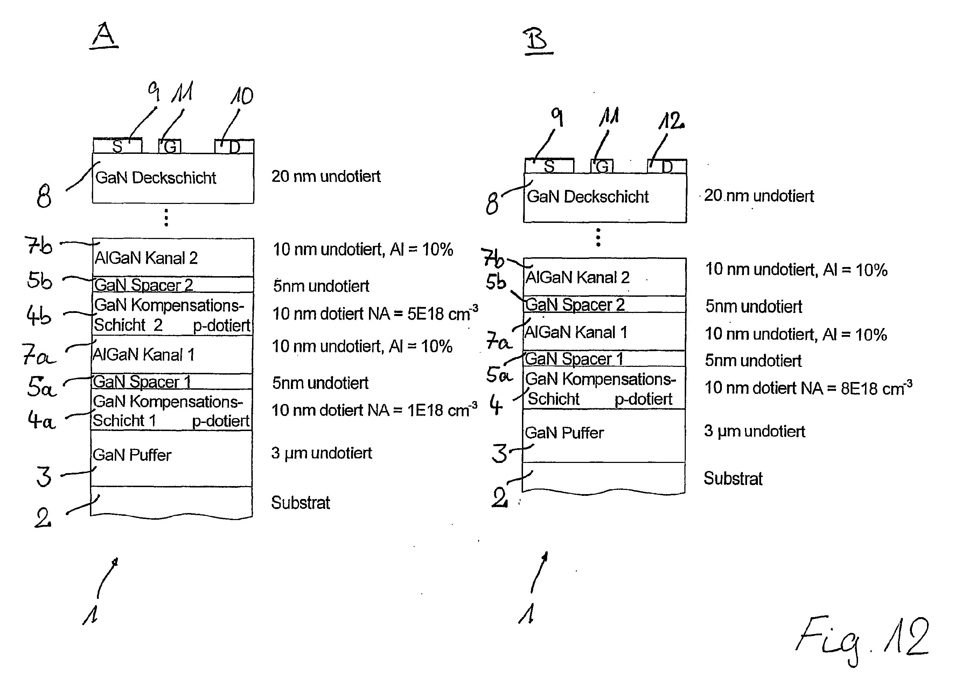

Nicht nur im GaN/InGaN/GaN Materialsystem sondern auch im GaN/AlGaN/GaN sind aufgrund der polaren Eigenschaften positive und negative Kanäle vorhanden. Auch im GaN/A1GaN/GaN System sind sowohl n-Kanal- und p-Kanal-Transistoren herstellbar. Zur Realisierung von n-Kanal- oder p-Kanal-Transistoren auf AlGaN-Basis werden analog zu InGaN-basierenden Heterostrukturen die unerwünschten Ladungsträger im GaN/AlGaN/GaN System durch Dotierung eines Bereichs um die Grenzschicht zwischen der Kanalschicht und einer ihr benachbarte Schicht kompensiert. In Fig. 12 ist beispielhaft ein p-Kanal Transistor im GaN/AlGaN/GaN System zu sehen, wobei in Fig. 12A für jede Kanalschicht 7a, 7b eine eigene dotierte Kompensationsschicht 4a, 4b vorgesehen ist, während in Fig. 12B nur der Bereich um die Grenzschicht zwischen dem untersten Kanal 7a und der Pufferschicht 3 als Kompensationsschicht 4 dotiert ist.

Analog zu den InGaN-basierenden Strukturen sind mehrere Schichtfolgen von AlGaN/GaN Quantentöpfen möglich mit einer Kompensationsdotierung zu Beginn des Quantentopfs oder mit je einer Kompensationsdotierung bei den jeweiligen Quantentöpfe oder bei einer bestimmten Auswahl bzw. Anzahl von A1 GaN/GaN Quantentöpfen.

Mit mehreren, z.B. unterschiedlich dotierten, AlGaN-Kanalschichten oder auch in Kombination mit einer GaN/ InGaN/ GaN-Struktur ist es ebenfalls möglich, n-Kanal- und p-Kanal-Transistoren für CMOS-ähnlichen Strukturen und Schaltungen ohne selektives Wachstum zu realisieren.

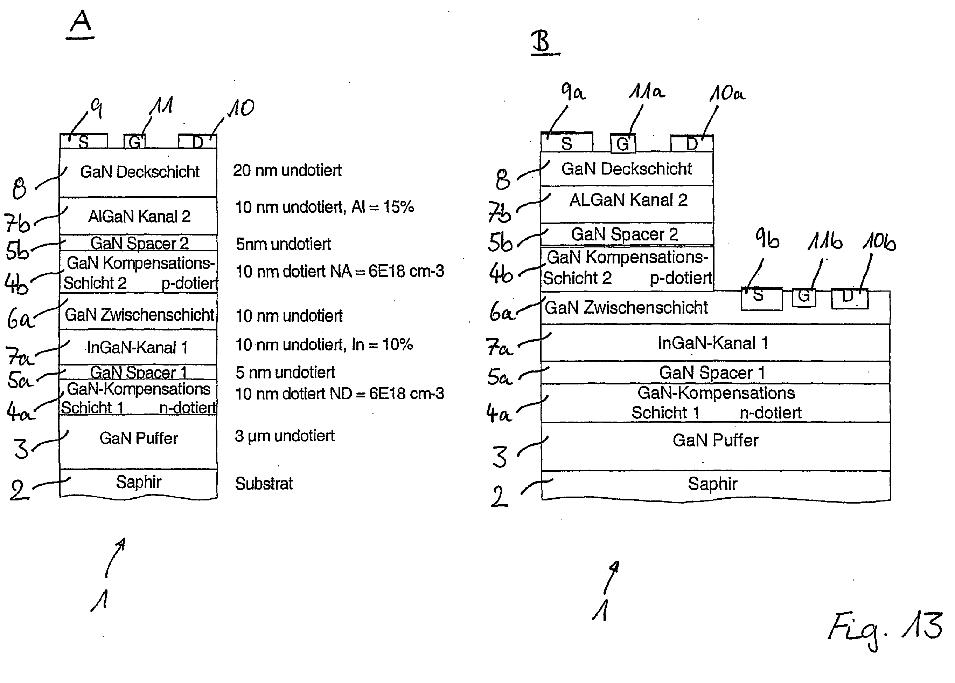

In den Fign. 13a und 13b ist die Realisierung einer CMOS-ähnlichen Struktur mit einem GaN/AlGaN/GaN-p-Kanal-FET mit einer Kompensationsdotierung für die Elektronen dargestellt. Der wirksame p-Kanal 7b liegt zwischen einer GaN-Deckschicht 8 und einer Spacer-Schicht 5b. Die Wirkungsweise des unterhalb der p-Kanalsschicht 7b und auf der Pufferschicht 3 angeordneten GaN/InGaN/GaN-n-Kanal-FET ist bereits oben beschrieben.

Der Aufbau der in Fig. 13b dargestellten Logikstruktur 1 aus der in Fig. 13a gezeigten Schichtstruktur erfolgt entsprechend der Beschreibung zu Fig. 10.

Damit ist es möglich, mit einer Kombination von GaN/AlGaN/GaN und GaN/InGaN/GaN Mehrkanal-Strukturen mit n- und p-Kanal durch richtige Positionierung der einzelnen Schichtfolgen und geeignete Kompensationsdortierung n- und p-Kanal Transistoren in derselben Struktur zu erzeugen für Anwendungen als CMOS-artige logische Schaltungen.

Es ist weiterhin möglich mit Hilfe von Kombinationen aus GaN/AlGaN/GaN und GaN/InGaN/GaN Mehrkanal-Strukturen Transistoren mit hoher Stromdichte und großer Linearität zu realisieren.

## Patentansprüche

1. Elektronisches Bauelement (1) mit einer Substratschicht (2) und einer darauf angeordneten Pufferschicht (3) und einer über der Pufferschicht (3) angeordneten Deckschicht (8), mindestens zwei zwischen der Pufferschicht (3) und der Deckschicht (8) angeordneten Kanalschichten (7a, 7b), wobei die Kanalschichten (7a, 7b) jeweils aus piezopolarem Material bestehen und zwischen je zwei benachbarten Kanalschichten (7a, 7b) mindestens eine Zwischenschicht (6) angeordnet ist, **dadurch gekennzeichnet daß**, zumindest der Bereich um eine der Grenzflächen zwischen der obersten Kanalschicht (7b, 7c) und/oder der untersten Kanalschicht (7a) und einer der der obersten bzw. untersten Kanalschicht (7a, 7b, 7c, ...) benachbart angeordneten Schichten (3, 4a, 5a, 4b, 5b, 8) unter Ausbildung einer Kompensationsschicht (4a, 4b) derart dotiert ist, daß die an der jeweiligen dotierten Grenzfläche auftretenden Piezoladungen teilweise oder vollständig kompensiert sind.

2. Bauelement nach dem vorhergehenden Anspruch, **dadurch gekennzeichnet, daß** zumindest der Bereich um eine der Grenzflächen zwischen der obersten Kanalschicht und der Deckschicht und/oder zwischen der untersten Kanalschicht und der Pufferschicht als Kompensationsschicht derart dotiert ist, daß die an der dotierten Grenzfläche auftretenden Piezoladungen kompensiert werden.

3. Bauelement nach einem der vorhergehenden Ansprüche, **dadurch gekennzeichnet, daß** nur der Bereich um eine der Grenzflächen zwischen der obersten Kanalschicht und der Deckschicht und/oder zwischen der untersten Kanalschicht und der Pufferschicht als Kompensationsschicht ausgebildet ist.

4. Bauelement nach einem der vorhergehenden Ansprüche, **dadurch gekennzeichnet, daß** der Bereich um die Grenzflächen zwischen mindestens zwei Kanalschichten und jeweils einer diesen auf derselben Seite oder auf verschiedenen Seiten benachbart angeordneten Zwischenschichten derart dotiert ist, daß die an der dotierten Grenzfläche auftretenden Piezoladungen kompensiert werden.

5. Bauelement nach einem der vorhergehenden Ansprüche, **dadurch gekennzeichnet, daß** mindestens eine Kompensationsschicht als dotierter Bereich der Kanalschicht ausgebildet ist.

6. Bauelement nach einem der vorhergehenden Ansprüche, **dadurch gekennzeichnet, daß** mindestens eine Kompensationsschicht als dotierter Bereich der Pufferschicht, Deckschicht und/oder Zwischenschicht ausgebildet ist.

7. Bauelement nach einem der beiden vorhergehenden Ansprüche, **dadurch gekennzeichnet, daß** die Kanalschicht, die Pufferschicht, die Deckschicht und/oder die Zwischenschicht in Richtung der Schichtabfolge betrachtet bereichsweise oder auch vollständig als Kompensationsschicht dotiert ist.

8. Bauelement nach einem der vorhergehenden Ansprüche, **dadurch gekennzeichnet, daß** mindestens eine Kompensationsschicht als dotierte Schicht zwischen der Kanalschicht und der der Kanalschicht benachbarten Pufferschicht, Zwischenschicht oder Deckschicht angeordnet ist.

9. Bauelement nach einem der vorhergehenden Ansprüche, **dadurch gekennzeichnet, daß** zwischen zumindest einer Kompensationsschicht und einer der ihr benachbart angeordneten Kanalschichten eine nicht dotierte Spacerschicht angeordnet ist.

10. Bauelement nach einem der vorhergehenden Ansprüche, **dadurch gekennzeichnet, daß** mindestens 3, 4 oder 5 Kanalschichten vorgesehen sind.

11. Bauelement nach einem der vorhergehenden Ansprüche, **dadurch gekennzeichnet, daß** die Dicke einer, mehrerer oder aller Kanalschichten und/oder Zwischenschichten zwischen 0,5 und 10 nm beträgt.

12. Bauelement nach einem der vorhergehenden Ansprüche, **dadurch gekennzeichnet, daß** der Bereich um die Grenzfläche zwischen einer, mehreren oder allen Kanalschichten und der benachbart angeordneten Pufferschicht, Deckschicht und/oder Zwischenschicht derart dotiert ist, daß die in dem Kanal vorhandenen piezoinduzierten negativen Ladungen kompensiert werden.

13. Bauelement nach einem der vorhergehenden Ansprüche, **dadurch gekennzeichnet, daß** der Bereich um die Grenzfläche zwischen einer, mehreren oder allen Kanalschichten und der benachbart angeordneten Pufferschicht, Deckschicht und/oder Zwischenschicht derart dotiert ist, daß die in dem Kanal vorhandenen piezoinduzierten positiven Ladungen kompensiert werden.

14. Bauelement nach einem der vorhergehenden Ansprüche, **dadurch gekennzeichnet, daß** eine, mehrere oder alle Kanalschichten eine InGaN-Schicht und/oder AlGaN-Schicht sind.

15. Bauelement nach dem vorhergehenden Anspruch, **dadurch gekennzeichnet, daß** der Indiumgehalt gegebenenfalls in zumindest einer, mehreren oder allen der InGaN-Schichten zwischen 1 % und 99 % je einschließlich beträgt.

16. Bauelement nach dem vorhergehenden Anspruch, **dadurch gekennzeichnet, daß** der Indiumgehalt in zumindest einer, mehreren oder allen der InGaN-Schichten zwischen 5 % und 30 % je einschließlich beträgt.

17. Bauelement nach dem vorhergehenden Anspruch, **dadurch gekennzeichnet, daß** der Indiumgehalt in zumindest einer, mehreren oder allen der InGaN-Schichten zwischen 7 % und 20 % je einschließlich beträgt.

18. Bauelement nach dem vorhergehenden Anspruch, **dadurch gekennzeichnet, daß** der Indiumgehalt in zumindest einer, mehreren oder allen der InGaN-Schichten 7 %, 10 % oder 20 % beträgt.

19. Bauelement nach einem der vorhergehenden Ansprüche, **dadurch gekennzeichnet, daß** die Pufferschicht und/oder Deckschicht eine GaN-Schicht ist.

20. Bauelement nach einem der vorhergehenden Ansprüche, **dadurch gekennzeichnet, daß** eine, mehrere und/oder alle Spacerschichten eine undotierte GaN-Schicht sind.

21. Bauelement nach einem der vorhergehenden Ansprüche, **dadurch gekennzeichnet, daß** eine, mehrere und/oder alle Zwischenschichten eine GaN-Schicht sind.

22. Bauelement nach einem der vorhergehenden Ansprüche, **dadurch gekennzeichnet, daß** eine, mehrere oder alle Kompensationsschichten ohne Berücksichtigung der Kompensationsdotierung eine chemische und/oder physikalische Zusammensetzung wie jeweils zumindest eine der ihr benachbarten Pufferschicht, Deckschicht, Zwischenschicht oder Kanalschicht aufweisen.

23. Bauelement nach einem der vorhergehenden Ansprüche, **dadurch gekennzeichnet, daß** die Dicke der Pufferschicht und/oder der Substratschicht zwischen 1 und 10 µm, der Zwischenschicht zwischen 5 und 50 nm, der Spacerschicht zwischen 1 und 20 nm, der Kanalschicht zwischen 5 und 50 nm und/oder der Deckschicht zwischen 5 und 50 nm beträgt.

24. Bauelement nach dem vorhergehenden Anspruch, **dadurch gekennzeichnet, daß** die Dicke der Pufferschicht und/oder der Substratschichten etwa 3 µm, einer, mehrerer oder aller Zwischenschicht etwa 10 nm, einer, mehrerer oder aller Spacerschichten etwa 5 nm, einer, mehrerer oder aller Kanalschichten etwa 10 nm oder 20 nm und/oder der Deckschicht etwa 20 nm beträgt.

25. Bauelement nach einem der vorhergehenden Ansprüche, **dadurch gekennzeichnet, daß** eine, mehrere oder alle Kompensationsschichten eine Donatordotierung zwischen 1 · 10¹⁸ cm⁻³ und 2 · 10¹⁹ cm⁻³ aufweisen.

26. Bauelement nach dem vorhergehenden Anspruch, **dadurch gekennzeichnet, daß** eine, mehrere oder alle Kompensationsschichten eine Donatordotierung zwischen 2 · 10¹⁸ cm⁻³ und 1 · 10¹⁹ cm⁻³ je einschließlich aufweisen.

27. Bauelement nach Anspruch 25, **dadurch gekennzeichnet, daß** eine, mehrere oder alle Kompensationsschichten eine Donatordotierung von 1 · 10¹⁸ cm⁻³ oder 2 · 10¹⁹ cm⁻³ aufweisen.

28. Bauelement nach einem der vorhergehenden Ansprüche, **dadurch gekennzeichnet, daß** der Dotierstoff einer, mehrerer oder aller Kompensationsschichten Silizium ist.

29. Bauelement nach einem der vorhergehenden Ansprüche, **dadurch gekennzeichnet, daß** eine, mehrere oder alle Kompensationsschichten eine Akzeptordotierung zwischen 1 · 10¹⁸ cm⁻³ und 5 · 10¹⁹ cm⁻³ aufweisen.

30. Bauelement nach dem vorhergehenden Anspruch, **dadurch gekennzeichnet, daß** eine, mehrere oder alle Kompensationsschichten eine Akzeptordotierung zwischen 2 · 10¹⁸ cm⁻³ und 2 · 10¹⁹ cm⁻³ je einschließlich aufweisen.

31. Bauelement nach dem vorhergehenden Anspruch, **dadurch gekennzeichnet, daß** eine, mehrere oder alle Kompensationsschichten eine Akzeptordotierung von 2 · 10¹⁹ cm-³ aufweisen.

32. Bauelement nach einem der vorhergehenden Ansprüche, **dadurch gekennzeichnet, daß** der Dotierstoff für die Dotierung einer, mehrerer oder aller Kompensationsschichten Magnesium ist.

33. Bauelement nach einem der vorhergehenden Ansprüchen, **dadurch gekennzeichnet, daß** auf Oberfläche der Deckschicht und/oder in der Pufferschicht vergraben zwei Kontaktelektroden (Quelle und Senke, bzw. Source- und Drainelektrode) und eine Steuerelektrode (Gateelektrode) angeordnet sind.

34. Bauelement nach Anspruchs 33, **dadurch gekennzeichnet, daß** die beiden Kontaktelektroden sperrfreie S- bzw. D-Kontakte sind.

35. Bauelement nach einem der Ansprüche 33 oder 34, **dadurch gekennzeichnet, daß** die Steuerelektrode eine Schottky-Metall-Steuerelektrode ist.

36. Bauelement nach einem der Ansprüche 33 bis 35, **dadurch gekennzeichnet, daß** die Steuerelektrode einen p⁻-dotierten Steuerkontakt aufweist.

37. Bauelement nach Anspruch 1, **gekennzeichnet durch**
eine Substratschicht,
eine auf der Substratschicht angeordnete GaN-Pufferschicht,
eine über der Pufferschicht angeordnete Deckschicht, sowie
mindestens zwei zwischen der Pufferschicht und der Deckschicht angeordnete InGaN-Kanalschichten, die **durch** GaN-Zwischenschichten voneinander getrennt sind,
wobei der Bereich um die Grenzflächen zwischen der untersten, mehreren oder jeder Kanalschicht und der unter ihr angeordneten und ihr benachbarten Schicht unter Ausbildung einer Kompensationsschicht derart dotiert ist, daß die piezoinduzierten positiven Ladungsträger in jeder der Kanalschichten teilweise oder vollständig kompensiert sind.

38. Bauelement nach Anspruch 1, **gekennzeichnet durch** eine Substratschicht,
eine auf der Substratschicht angeordnete GaN-Pufferschicht,
eine über der Pufferschicht angeordnete Deckschicht, sowie
mindestens zwei zwischen der Pufferschicht und der Deckschicht angeordnete InGaN-Kanalschichten, die **durch** GaN-Zwischenschichten voneinander getrennt sind,
wobei der Bereich um die Grenzflächen zwischen der obersten, mehreren oder jeder Kanalschicht und der über ihr angeordneten und ihr benachbarten Schicht unter Ausbildung einer Kompensationsschicht derart dotiert ist, daß die piezoinduzierten negativen Ladungsträger in jeder der Kanalschichten teilweise oder vollständig kompensiert sind.

39. Bauelement nach Anspruch 1, **gekennzeichnet durch** eine Substratschicht,
eine auf der Substratschicht angeordnete GaN-Pufferschicht, eine über der Pufferschicht angeordnete Deckschicht, sowie
mindestens zwei zwischen der Pufferschicht und der Deckschicht angeordnete AlGaN-Kanalschichten, die **durch** GaN-Zwischenschichten voneinander getrennt sind
wobei der Bereich um die Grenzflächen zwischen der obersten, mehreren oder jeder Kanalschicht und der über ihr angeordneten und ihr benachbarten Schicht unter Ausbildung einer Kompensationsschicht derart dotiert ist, daß die piezoinduzierten positiven Ladungsträger in jeder der Kanalschichten teilweise oder vollständig kompensiert sind.

40. Bauelement nach Anspruch 1, **gekennzeichnet durch** eine Substratschicht,
eine auf der Substratschicht angeordnete GaN-Pufferschicht:
eine über der Pufferschicht angeordnete Deckschicht, sowie
mindestens zwei zwischen der Pufferschicht und der Deckschicht angeordnete AlGaN-Kanalschichten, die **durch** GaN-Zwischenschichten voneinander getrennt sind
wobei der Bereich um die Grenzflächen zwischen der untersten, mehreren oder jeder Kanalschicht und der unter ihr angeordneten und ihr benachbarten Schicht unter Ausbildung einer Kompensationsschicht derart dotiert ist, daß die piezoinduzierten negativen Ladungsträger in jeder der Kanalschichten teilweise oder vollständig kompensiert sind.

41. Bauelement nach Anspruch 1, **gekennzeichnet durch** eine Substratschicht,
eine auf der Substratschicht angeordnete GaN-Pufferschicht,
eine über der Pufferschicht angeordnete Deckschicht, sowie
zwischen der Pufferschicht und der Deckschicht angeordnet eine Abfolge von mindestens einer InGaN-Kanalschicht und eine Abfolge von mindestens einer AlGaN-Kanalschicht, wobei die Kanalschichten jeweils **durch** eine GaN-Zwischenschicht voneinander getrennt sind, und
wobei der Bereich um die Grenzflächen zwischen einer, mehreren oder jeder Kanalschicht und der über oder unter ihr angeordneten und ihr benachbarten Schicht unter Ausbildung einer Kompensationsschicht derart dotiert ist, daß für jede Kanalschichtabfolge die piezoinduzierten positiven oder negativen Ladungsträger lediglich einer Ladungsträgerart in jeder der Kanalschichten der jeweiligen Kanalschichtabfolge teilweise oder vollständig kompensiert sind.

42. Bauelement nach Anspruch 1, **gekennzeichnet durch** eine Substratschicht,
eine auf der Substratschicht angeordnete GaN-Pufferschicht,
eine über der Pufferschicht angeordnete Deckschicht, sowie
zwischen der Pufferschicht und der Deckschicht angeordnet eine Abfolge von mindestens einer InGaN-Kanalschicht und eine Abfolge von mindestens einer AlGaN-Kanalschicht,
wobei die Kanalschichten jeweils **durch** eine GaN-Zwischenschicht voneinander getrennt sind und
wobei der Bereich um die Grenzfläche zwischen obersten Kanalschicht und/oder der untersten Kanalschicht jeder Abfolge und der jeweiligen über oder unter ihr angeordneten und ihr benachbarten Schicht unter Ausbildung einer Kompensationsschicht derart dotiert ist, daß die piezoinduzierten Ladungsträger lediglich einer Ladungsträgerart in jeder der Kanalschichten der jeweiligen Kanalschichtenabfolge teilweise oder vollständig kompensiert sind.

43. Bauelement nach einem der beiden vorhergehenden Ansprüche, **dadurch gekennzeichnet, daß** die oberste Kanalschichtabfolge die untere Kanalschichtabfolge in der Schichtenebene betrachtet zumindest bereichsweise nicht überdeckt.

44. Bauelement nach dem vorhergehenden Anspruch, **dadurch gekennzeichnet, daß** die freiliegenden Bereiche der unteren und der oberen Kanalschichtabfolge jeweils zwei Kontaktelektroden (Quelle und Senke bzw. Sourceelektrode und Drainelektrode) sowie eine Steuerelektrode (Gateelektrode) aufweisen.

45. Bauelement nach einem der Ansprüche 37 bis 44,
**dadurch gekennzeichnet, daß** zwischen einer, mehreren oder allen Kompensationsschichten und der jeweiligen benachbarten Kanalschicht eine GaN-Spacerschicht angeordnet ist.

46. Verwendung von Bauelementen nach einem der vorhergehenden Ansprüche als Heterostuktur, für die Leistungselektronik oder Hochtemperaturelektronik, in Feldeffekttransistoren oder Logikschaltungen, insbesondere kompementären Logikschaltungen und CMOS-artigen Logikschaltungen.

47. Verwendung nach dem vorhergehenden Anspruch im Bereich der Mobilfunktechnik oder der Radartechnik.

## Claims

1. Electronic component (1) comprising a substrate layer (2) with a buffer layer (3) arranged thereon and a cover layer (8) arranged over said buffer layer (3), at least two channel layers (7a, 7b) arranged between the buffer layer (3) and the cover layer (8), the channel layers (7a, 7b) each being made of piezopolar material and at least one intermediate layer (6) being arranged between each pair of adjacent channel layers (7a, 7b), **characterised in that** at least the region around one of the interfaces between the uppermost channel layer (7b, 7c) and/or the lowermost channel (7a) and one of the layers (3, 4a, 5a, 4b, 5b, 8) arranged adjacent to the uppermost or lowermost channel layer (7a, 7b, 7c, etc.) is, when a compensation layer (4a, 4b) is formed, doped in such a way that the piezo charges acting on the respective doped interface are compensated either in part or in full.

2. Component according to the preceding claim, **characterised in that** at least the region around one of the interfaces between the uppermost channel layer and the cover layer and/or between the lowermost channel layer and the buffer layer is doped as a compensation layer in such a way that the piezo charges acting on the doped interface are compensated.

3. Component according to any one of the preceding claims, **characterised in that** only the region around one of the interfaces between the uppermost channel layer and the cover layer and/or between the lowermost channel layer and the buffer layer is configured as a compensation layer.

4. Component according to any one of the preceding claims, **characterised in that** the region around the interfaces between at least two channel layers and a respective one of said intermediate layers arranged adjacently on the same side or on different sides is doped in such a way that the piezo charges acting on the doped interface are compensated.

5. Component according to any one of the preceding claims, **characterised in that** at least one compensation layer is configured as a doped region of the channel layer.

6. Component according to any one of the preceding claims, **characterised in that** at least one compensation layer is configured as a doped region of the buffer layer, cover layer and/or intermediate layer.

7. Component according to either of the two preceding claims, **characterised in that** the channel layer, the buffer layer, the cover layer and/or the intermediate layer is doped as a compensation layer in the direction of the layer sequence considered in specific regions or even in full.

8. Component according to any one of the preceding claims, **characterised in that** at least one compensation layer is arranged as a doped layer between the channel layer and the buffer layer, intermediate layer or cover layer adjacent to the channel layer.

9. Component according to any one of the preceding claims, **characterised in that** an undoped spacer layer is arranged between at least one compensation layer and one of the channel layers arranged adjacent thereto.

10. Component according to any one of the preceding claims, **characterised in that** at least 3, 4 or 5 channel layers are provided.

11. Component according to any one of the preceding claims, **characterised in that** one, more than one or all of the channel layers and/or intermediate layers are between 0.5 and 10 nm thick.

12. Component according to any one of the preceding claims, **characterised in that** the region around the interface between one, more than one or all of the channel layers and the buffer layer, cover layer and/or intermediate layer arranged adjacent thereto is doped in such a way that the piezo-induced negative charges present in the channel are compensated.

13. Component according to any one of the preceding claims, **characterised in that** the region around the interface between one, more than one or all of the channel layers and the buffer layer, cover layer and/or intermediate layer arranged adjacent thereto is doped in such a way that the piezo-induced positive charges present in the channel are compensated.

14. Component according to any one of the preceding claims, **characterised in that** one, more than one or all of the channel layers are an InGaN layer and/or A1GaN layer.

15. Component according to the preceding claim, **characterised in that** the indium content optionally in at least one, more than one or all of the InGaN layers is between 1 % and 99 % inclusive.

16. Component according to the preceding claim, **characterised in that** the indium content in at least one, more than one or all of the InGaN layers is between 5 % and 30 % inclusive.

17. Component according to the preceding claim, **characterised in that** the indium content in at least one, more than one or all of the InGaN layers is between 7 % and 20 % inclusive.

18. Component according to the preceding claim, **characterised in that** the indium content in at least one, more than one, or all of the InGaN layers is 7 %, 10 % or 20 %.

19. Component according to any one of the preceding claims, **characterised in that** the buffer layer and/or cover layer is a GaN layer.

20. Component according to any one of the preceding claims, **characterised in that** one, more than one and/or all spacer layers are an undoped GaN layer.

21. Component according to any one of the preceding claims, **characterised in that** one, more than one and/or all of the intermediate layers are a GaN layer.

22. Component according to any one of the preceding claims, **characterised in that** one, more than one or all of the compensation layers, without considering compensation doping, comprise a chemical and/or physical composition like at least a respective one of the buffer, cover, intermediate or channel layers adjacent thereto.

23. Component according to any one of the preceding claims, **characterised in that** the buffer layer and/or the substrate layer are/is between 1 and 10 µm thick, the intermediate layer is between 5 and 50 nm thick, the spacer layer is between 1 and 20 nm thick, the channel layer is between 5 and 50 nm thick and/or the cover layer is between 5 and 50 nm thick.

24. Component according to the preceding claim, **characterised in that** the buffer layer and/or the substrate layers are approximately 3 µm thick, one, more than one or all of the intermediate layers are between 10 nm thick, one, more than one or all of the spacer layers are approximately 5 nm thick, one, more than one or all of the channel layers are approximately 10 nm or 20 nm thick and/or the cover layer is approximately 20 nm thick.

25. Component according to any one of the preceding claims, **characterised in that** one, more than one or all of the compensation layers comprise a donor doping between 1 • 10¹⁸ cm⁻³ and 2 • 10¹⁹ cm⁻³.

26. Component according to the preceding claim, **characterised in that** one, more than one or all of the compensation layers each comprise a donor doping between 2 • 10¹⁸ cm⁻³ and 1 • 10¹⁹cm⁻³ inclusive.

27. Component according to claim 25, **characterised in that** one, more than one or all of the compensation layers comprise a donor doping of 1 • 10¹⁸ cm⁻³ or 2 • 10¹⁹ cm⁻³.

28. Component according to any one of the preceding claims, **characterised in that** the doping material of one, more than one or all of the compensation layers is silicon.

29. Component according to any one of the preceding claims, **characterised in that** one, more than one or all of the compensation layers comprise an acceptor doping between 1 • 10¹⁸cm⁻³ and 5 • 10¹⁹ cm⁻³.

30. Component according to the preceding claim 1, **characterised in that** one, more than one or all of the compensation layers each comprise an acceptor doping between 2 • 10¹⁸ cm⁻³ and 2 • 10⁻¹⁹ cm⁻³ inclusive.

31. Component according to the preceding claim, **characterised in that** one, more than one or all of the compensation layers comprise an acceptor doping of 2 • 10¹⁹ cm⁻³.

32. Component according to any one of the preceding claims, **characterised in that** the doping material used for doping one, more than one or all of the compensation layers is magnesium.

33. Component according to any one of the preceding claims, **characterised in that** two contact electrodes (source and sink, or source and drain electrodes) and a control electrode (gate electrode) are arranged on the surface of the cover layer and/or buried in the buffer layer.

34. Component according to claim 33, **characterised in that** the two contact electrodes are non-rectifying S and D contacts.

35. Component according to either claim 33 or claim 34, **characterised in that** the control electrode is a Schottky metal control electrode.

36. Component according to any one of claims 33 to 35, **characterised in that** the control electrode comprises a p-doped control contact.

37. Component according to claim 1, **characterised by** a substrate layer, a GaN buffer layer arranged on the substrate layer, a cover layer arranged over the buffer layer, and at least two InGaN channel layers arranged between the buffer layer and the cover layer and separated from one another by GaN intermediate layers, the region around the interfaces between the lowermost, more than one or each channel layer and the layer arranged therebeneath and adjacent thereto is, when a compensation layer is formed, doped in such a way that the piezo-induced positive charge carriers in each of the channel layers is compensated either in part or in full.

38. Component according to claim 1, **characterised by** a substrate layer, a GaN buffer layer arranged on the substrate layer, a cover layer arranged over the buffer layer, and at least two InGaN channel layers arranged between the buffer layer and the cover layer and separated from one another by GaN intermediate layers, the region around the interfaces between the uppermost, more than one or each channel layer and the layer arranged thereabove and adjacent thereto is, when a compensation layer is formed, doped in such a way that the piezo-induced negative charge carriers in each of the channel layers are compensated either in part or in full.

39. Component according to claim 1, **characterised by** a substrate layer, a GaN buffer layer arranged on the substrate layer, a cover layer arranged over the buffer layer, and at least two AlGaN channel layers arranged between the buffer layer and the cover layer and separated from one another by GaN intermediate layers, the region around the interfaces between the uppermost, more than one or each channel layer and the layer arranged thereabove and adjacent thereto is, when a compensation layer is formed, doped in such a way that the piezo-induced positive charge carriers in each of the channel layers are compensated either in part or in full.

40. Component according to claim 1, **characterised by** a substrate layer, a GaN buffer layer arranged on the substrate layer, a cover layer arranged over the buffer layer, and at least two A1GaN channel layers arranged between the buffer layer and the cover layer and separated from one another by GaN intermediate layers, the region around the interfaces between the lowermost, more than one or each channel layer and the layer arranged therebeneath and adjacent thereto is, when a compensation layer is formed, doped in such a way that the piezo-induced negative charge carriers in each of the channel layers are compensated either in part or in full.

41. Component according to claim 1, **characterised by** a substrate layer, a GaN buffer layer arranged on the substrate layer, a cover layer arranged over the buffer layer, and a sequence of at least one InGaN channel layer and a sequence of at least one AIGaN channel layer arranged between the buffer layer and the cover layer, the channel layers each being separated from one another by a GaN intermediate layer and the region around the interfaces between one, more than one or each channel layer and the layer arranged thereabove or therebeneath and adjacent thereto being, when a compensation layer is formed, doped in such a way that for each channel layer sequence the piezo-induced positive or negative charge carriers comprising only one type of charge carrier in each of the channel layers of the respective channel layer sequence are compensated either in part or in full.

42. Component according to claim 1, **characterised by** a substrate layer, a GaN buffer layer arranged on the substrate layer, a cover layer arranged over the buffer layer, and a sequence of at least one InGaN channel layer and a sequence of at least one AIGaN channel layer arranged between the buffer layer and the cover layer, the channel layers each being separated from one another by a GaN intermediate layer and the region around the interface between the uppermost channel layer and/or the lowermost channel layer of each sequence and the respective layer arranged thereabove or therebeneath and adjacent thereto being, when a compensation layer is formed, doped in such a way that the piezo-induced charge carriers comprising only one type of charge carrier in each of the channel layers of the respective sequence of channel layers are compensated either in part or in full.

43. Component according to either of the two preceding claims, **characterised in that** the uppermost channel layer sequence does not overlap the lower channel layer sequence in the plane of layers considered, at least in parts.

44. Component according to the preceding claim, **characterised in that** the exposed regions of the upper and lower channel layer sequence each comprise two contact electrodes (source and sink, or source and drain electrodes) as well as a control electrode (gate electrode).

45. Component according to any one of claims 37 to 44, **characterised in that** a GaN spacer layer is arranged between one, more than one or all of the compensation layers and the respective adjacent channel layer.

46. Use of components according to any one of the preceding claims as a heterostructure for power electronics or high-temperature electronics in field effect transistors or logic circuits, in particular in complementary logic circuits and CMOS-type logic circuits.

47. Use according to the preceding claim in the field of mobile radio engineering or radar engineering.

## Revendications

1. Composant électrique (1) comprenant une couche de substrat (2) et une couche tampon (3) disposée dessus et une couche de revêtement (8) disposée au-dessus de la couche tampon (3), au moins deux couches de canal (7a, 7b) disposées entre la couche tampon (3) et la couche de revêtement (8), les couches de canal (7a, 7b) étant chacune à base de matériau piézo-polaire et au moins une couche intermédiaire (6) étant disposée entre respectivement deux couches de canal (7a, 7b) voisines, **caractérisé en ce qu'**au moins la zone autour d'une des surfaces limites entre la couche de canal (7b, 7c) supérieure et/ou la couche de canal (7a) inférieure et une des couches (3, 4a, 5a, 4b, 5b, 8) voisines de la couche de canal (7a, 7b, 7c, ...) supérieure ou inférieure est dopée en formant une couche de compensation (4a, 4b) ; de telle sorte que les charges piézoélectriques apparaissant sur la surface limite dopée concernée sont en partie ou complètement compensées.

2. Composant selon la revendication précédente **caractérisé en ce qu'**au moins la zone autour de l'une des surfaces limites entre la couche de canal supérieure et la couche de revêtement et/ou entre la couche de canal inférieure et la couche tampon en tant que couche de compensation est dopée, de telle sorte que les charges piézoélectriques apparaissant sur la surface limite dopée sont compensées.

3. Composant selon l'une quelconque des revendications précédentes, **caractérisé en ce que** seule la zone autour de l'une des surfaces limites entre la couche de canal supérieure et la couche de revêtement et/ou entre la couche de canal inférieure et la couche tampon est conçue en tant que couche de compensation.

4. Composant selon l'une quelconque des revendications précédentes, **caractérisé en ce que** la zone autour des surfaces limites entre au moins deux couches de canal et respectivement une des couches intermédiaires disposées à proximité sur le même côté ou sur différents côtés est dopée, de telle sorte que les charges piézoélectriques apparaissant sur la surface limite dopée sont compensées.

5. Composant selon l'une quelconque des revendications précédentes, **caractérisé en ce qu'**au moins une couche de compensation est réalisée sous forme de zone dopée de la couche de canal.

6. Composant selon l'une quelconque des revendications précédentes, **caractérisé en ce qu'**au moins une couche de compensation est réalisée sous forme de zone dopée de la couche tampon, de la couche de revêtement et/ou de la couche intermédiaire.

7. Composant selon l'une quelconque des deux revendications précédentes, **caractérisé en ce que** la couche de canal, la couche tampon, la couche de revêtement et/ou la couche intermédiaire sont dopées, vu en direction de la succession de couches, par zones ou également complètement en tant que couche de compensation.

8. Composant selon l'une quelconque des revendications précédentes, **caractérisé en ce qu'**au moins une couche de compensation est disposée en tant que couche dopée entre la couche de canal et la couche tampon, la couche intermédiaire ou la couche de revêtement voisine de la couche de canal.

9. Composant selon l'une quelconque des revendications précédentes, **caractérisé en ce qu'**une couche d'espacement non dopée est disposée entre au moins une couche de compensation et l'une des couches de canal disposées à proximité de la première.

10. Composant selon l'une quelconque des revendications précédentes, **caractérisé en ce qu'**au moins 3, 4 ou 5 couches de canal sont prévues.

11. Composant selon l'une quelconque des revendications précédentes, **caractérisé en ce que** l'épaisseur d'une, de plusieurs ou de toutes les couches de canal et/ou couches intermédiaires se situe entre 0,5 et 10 nm.

12. Composant selon l'une quelconque des revendications précédentes, **caractérisé en ce que** la zone autour de la surface limite entre une, plusieurs ou toutes les couches de canal et la couche tampon, la couche de revêtement et/ou la couche intermédiaire disposée à proximité est dopée, de telle sorte que les charges négatives induites de façon piézo-électrique et présentes dans le canal sont compensées.

13. Composant selon l'une quelconque des revendications précédentes, **caractérisé en ce que** la zone autour de la surface limite entre une, plusieurs ou toutes les couches de canal et la couche tampon, la couche de revêtement et/ou la couche intermédiaire disposée à proximité est dopée, de telle sorte que les charges positives induites de façon piézo-électrique et présentes dans le canal sont compensées.

14. Composant selon l'une quelconque des revendications précédentes, **caractérisé en ce qu'**une, plusieurs ou toutes les couches de canal sont une couche InGaN et/ou une couche AIGaN.

15. Composant selon la revendication précédente, **caractérisé en ce que** la teneur en indium se situe éventuellement dans au moins une, plusieurs ou l'ensemble des couches InGaN entre 1 % et 99 % inclus.

16. Composant selon la revendication précédente, **caractérisé en ce que** la teneur en Indium dans au moins une, plusieurs ou l'ensemble des couches InGaN se situe entre 5 % et 30 % inclus.

17. Composant selon la revendication précédente, **caractérisé en ce que** la teneur en Indium dans au moins une, plusieurs ou l'ensemble des couches InGaN se situe entre 7 % et 20 % inclus.

18. Composant selon la revendication précédente, **caractérisé en ce que** la teneur en Indium dans au moins une, plusieurs ou l'ensemble des couches InGaN s'élève à 7 %, 10 % ou 20 %.

19. Composant selon l'une quelconque des revendications précédentes, **caractérisé en ce que** la couche tampon et/ou la couche de revêtement est une couche GaN.

20. Composant selon l'une quelconque des revendications précédentes, **caractérisé en ce qu'**une, plusieurs et/ou l'ensemble des couches d'écartement sont une couche GaN non dopée.

21. Composant selon l'une quelconque des revendications précédentes, **caractérisé en ce qu'**une, plusieurs et/ou toutes les couches intermédiaires sont une couche GaN.

22. Composant selon l'une quelconque des revendications précédentes, **caractérisé en ce qu'**une, plusieurs et/ou toutes les couches de compensation présentent sans la prise en compte du dopage de compensation une position chimique et/ou physique comme à chaque fois au moins une couche tampon, de revêtement, intermédiaire ou de canal voisine de la première.

23. Composant selon l'une quelconque des revendications précédentes, **caractérisé en ce que** l'épaisseur de la couche tampon et/ou de la couche de substrat se situe entre 1 et 10 µm, celle de la couche intermédiaire entre 5 et 10 nm, celle de la couche spacer entre 1 et 20 nm, celle de la couche de canal entre 5 et 50 nm et/ou celle de la couche de revêtement entre 5 et 50 nm.

24. Composant selon la revendication précédente, **caractérisé en ce que** l'épaisseur de la couche tampon et/ou de la couche de substrat est d'environ 3 µm, celle d'une, de plusieurs ou de toutes les couches intermédiaires d'environ 10 nm, celle d'une, de plusieurs ou de toutes les couches spacer d'environ 5 nm, celle d'une, de plusieurs ou de toutes les couches de canal d'environ 10 nm ou 20 nm et/ou de la couche de revêtement d'environ 20 nm.

25. Composant selon l'une quelconque des revendications précédentes, **caractérisé en ce qu'**une, plusieurs ou l'ensemble des couches de compensation présentent un dopage par donneur entre 1.10¹⁸ cm⁻³ et 2.10¹⁹ cm⁻³.

26. Composant selon la revendication précédente, **caractérisé en ce qu'**une, plusieurs ou toutes les couches de compensation présentent un dopage par donneur compris entre 2.10¹⁹cm⁻³ et 1.10¹⁹ cm⁻³ inclus.

27. Composant selon la revendication 25, **caractérisé en ce qu'**une, plusieurs ou toutes les couches de compensation présentent un dopage par donneur de 1.10¹⁸ cm⁻³ ou 2.10¹⁹ cm⁻³.

28. Composant selon l'une quelconque des revendications précédentes, **caractérisé en ce que** la matière de dopage d'une, de plusieurs ou de toutes les couches de compensation est du silicium.

29. Composant selon l'une quelconque des revendications précédentes, **caractérisé en ce qu'**une, plusieurs ou toutes les couches de compensation présentent un dopage par accepteur compris entre 1.10¹⁸ cm⁻³ et 5.10¹⁹ cm⁻³.

30. Composant selon la revendication précédente, **caractérisé en ce qu'**une, plusieurs ou toutes les couches de compensation présentent un dopage par accepteur compris entre 2.10¹⁸cm⁻³ et 2.10¹⁹cm⁻³ inclus.

31. Composant selon la revendication précédente, **caractérisé en ce qu'**une, plusieurs ou toutes les couches de compensation présentent un dopage par accepteur de 2.10¹⁹ cm⁻³.

32. Composant selon l'une quelconque des revendications précédentes, **caractérisé en ce que** la matière de dopage pour le dopage d'une, de plusieurs ou de toutes les couches de compensation est du magnésium.

33. Composant selon l'une quelconque des revendications précédentes, **caractérisé en ce que** deux électrodes de contact (source et drain respectivement électrode de source et électrode de drain) et une électrode de commande (électrode de porte) sont disposées enfouies à la surface de la couche de revêtement et/ou dans la couche tampon.

34. Elément selon la revendication 33, **caractérisé en ce que** les deux électrodes de contact sont des contacts S ou D sans blocage.

35. Composant selon l'une quelconque des revendications 33 ou 34, **caractérisé en ce que** l'électrode de commande est une électrode de commande en métal de Schottky.

36. Composant selon l'une quelconque des revendications 33 à 35, **caractérisé en ce que** l'électrode de commande présente un contact de commande à dopage p.

37. Composant selon la revendication 1, **caractérisé par** une couche de substrat,
une couche tampon GaN disposée sur la couche de substrat,
une couche de revêtement disposée sur la couche tampon, ainsi que
au moins deux couches de canal InGaN disposées entre la couche tampon et la couche de revêtement, qui sont séparées l'une de l'autre par des couches intermédiaires GaN,
la zone autour des surfaces limites entre la couche de canal inférieure, plusieurs couches de canal ou chaque couche de canal et la couche disposée au-dessous de cette couche et voisine de celle-ci est dopée en formant une couche de compensation, de telle sorte que les porteurs de charges positives induites de façon piézo-électrique sont partiellement ou complètement compensés dans chacune des couches de canal.

38. Composant selon la revendication 1, **caractérisé par** une couche de substrat,
une couche tampon GaN disposée sur la couche de substrat,
une couche de revêtement disposée au-dessus de la couche tampon, ainsi que
au moins deux couches de canal InGaN disposées entre la couche tampon et la couche de revêtement, qui sont séparées l'une de l'autre par des couches intermédiaires GaN,
la zone autour des surfaces limites entre la couche de canal supérieure, plusieurs couches de canal ou chaque couche de canal et la couche disposée au-dessus de cette couche et voisine de celle-ci étant dopée en formant une couche de compensation, de telle sorte que les porteurs de charges négatives induites de façon piézo-électrique sont partiellement ou complètement compensés dans chacune des couches de canal.

39. Composant selon la revendication 1, **caractérisé par** une couche de substrat,
une couche tampon GaN disposée sur la couche de substrat, une couche de revêtement disposée au-dessus de la couche tampon, ainsi que
au moins deux couches de canal AIGaN disposées entre la couche tampon et la couche de revêtement, qui sont séparées l'une de l'autre par des couches intermédiaires GaN,
la zone autour des surfaces limites entre la couche de canal supérieure, plusieurs couches de canal ou chaque couche de canal et la couche disposée au-dessus d'elle et voisine de celle-ci étant dopée en formant une couche de compensation, de telle sorte que les porteurs de charges positives induites de façon piézo-électrique sont partiellement ou complètement compensés dans chacune des couches de canal.

40. Composant selon la revendication 1, **caractérisé par** une couche de substrat,
une couche tampon GaN disposée sur la couche de substrat,
une couche de revêtement disposée au-dessus de la couche tampon, ainsi que
au moins deux couches de canal AIGaN disposées entre la couche tampon et la couche de revêtement, qui sont séparées l'une de l'autre par des couches intermédiaires GaN,
la zone autour des surfaces limites entre la couche de canal inférieure, plusieurs couches de canal ou chaque couche de canal et la couche disposée au-dessous d'elle et voisine de celle-ci étant dopée en formant une couche de compensation, de telle sorte que les porteurs de charges négatives induites de façon piézo-électrique sont partiellement ou complètement compensés dans chacune des couches de canal.

41. Composant selon la revendication 1, **caractérisé par** une couche de substrat,
une couche tampon GaN disposée sur la couche de substrat,
une couche de revêtement disposée au-dessus de la couche tampon, ainsi que
disposée entre la couche tampon et la couche de revêtement, une succession d'au moins une couche de canal InGaN et une succession d'au moins une couche de canal AIGaN, les couches de canal étant séparées les unes des autres respectivement par une couche intermédiaire GaN, et
la zone autour des surfaces limites entre une couche de canal, plusieurs couches de canal ou chaque couche de canal et la couche disposée au-dessus ou au-dessous d'elle et voisine de celle-ci étant dopée en formant une couche de compensation de telle sorte que, pour chaque succession de couches de canal, les porteurs de charges positives ou négatives, induites de façon piézo-électrique de uniquement un type de porteur de charge sont partiellement ou complètement compensés dans chacune des couches de canal de la succession respective de couches de canal.

42. Composant selon la revendication 1, **caractérisé par** une couche de substrat,
une couche tampon GaN disposée sur la couche de substrat,
une couche de revêtement disposée au-dessus de la couche tampon, ainsi que,
disposée entre la couche tampon et la couche de revêtement, une succession d'au moins une couche de canal InGaN et une succession d'au moins une couche de canal AIGaN,
les couches de canal étant séparées les unes des autres respectivement par une couche intermédiaire GaN et la zone autour de la surface limite entre la couche de canal supérieure et/ou la couche de canal inférieure de chaque succession et la couche respective disposée au-dessus ou au-dessous de cette succession et voisine de celle-ci étant dopée en formant une couche de compensation, de telle sorte que les porteurs de charges induites de façon piézo-électrique de seulement un type de porteur de charge sont partiellement ou complètement compensés dans chacune des couches de canal de la succession respective de couches de canal.

43. Composant selon l'une quelconque des deux revendications précédentes, **caractérisé en ce que** la succession supérieure de couches de canal ne recouvre pas au moins par endroit la succession inférieure de couches de canal, vu dans le plan de couches.

44. Composant selon la revendication précédente, **caractérisé en ce que** les zones dégagées des successions supérieures et inférieures de couches de canal présentent respectivement deux électrodes de contact (source et drain respectivement électrode de source et électrode de drain) ainsi qu'une électrode de commande (électrode de porte).

45. Composant selon l'une quelconque des revendications 37 à 44, **caractérisé en ce qu'**une couche d'espacement GaN est disposée entre une, plusieurs ou toutes les couches de compensation et la couche de canal voisine respective.

46. Utilisation de composants selon l'une quelconque des revendications précédentes comme hétérostructure, pour l'électronique de puissance ou l'électronique de température élevée, dans des transistors à effet de champ ou des circuits logiques, en particulier des circuits logiques complémentaires et des circuits logiques de type CMOS.

47. Utilisation selon la revendication précédente dans la zone de technique de téléphonie mobile ou la technique radar.
